# EUROPEAN PATENT APPLICATION

(11) **EP 4 170 364 A1**
(43) Date of publication of application: **26.04.2023**
(21) Application number: 21382954.2
(22) Date of filing: 22.10.2021
(51) Int. Cl.: G01R 31/26

(54) **POWER CONVERTERS**

(71) Applicant: General Electric Renovables España S.L., 08005 Barcelona (ES)
(72) Inventor: WANG, Honggang, Niskayuna, 12309-1027 (US); HE, Lijun, Niskayuna, 12309-1027 (US); SAXENA, Abhinav, San Ramon, 94583 (US); TEMPLIER, Luc, 44200 Nantes (FR); PERON, Virginie, 44200 Nantes (FR)
(74) Representative: de Rooij, Mathieu Julien

(57) **Abstract**

The present disclosure provides examples of methods and systems for estimating an operational state of a semiconductor chip of a power semiconductor device which are based on determining a parameter indicative of an operational state of the semiconductor chip including an indication of uncertainty of the operational state based on the received operational data. The present disclosure further provides examples of methods and systems for predicting remaining useful life of a semiconductor chip.

## Description

The present disclosure relates to power converters, and more particularly relates to methods and systems for determining an operational state of a power semiconductor device in a power converter. The present disclosure further relates to methods and systems for estimating the cumulative life usage or life usage rate and a peak junction temperature of a semiconductor chip in a power device, and particularly of a power device in a power electronic converter coupled to a generator of a wind turbine. The present disclosure further relates to methods and systems for predicting remaining useful life of a semiconductor chip, and particularly of semiconductor chips used in power converters connected to a wind turbine.

### BACKGROUND

Modern wind turbines are used for supplying electricity to the grid. A wind turbine generally includes a tower with a nacelle supported on top of the tower. A wind turbine rotor comprising a hub and a plurality of wind turbine blades may be rotatably mounted to the nacelle.

The wind turbine blades may be set in motion by wind. The hub of the wind turbine may be operatively coupled with a rotor of a generator. As the hub and blades rotate, the kinetic energy of the wind is converted to kinetic mechanical energy of the wind turbine rotor and ultimately to electrical energy or power in the generator. The generator may typically be arranged inside the nacelle.

The wind turbine rotor may be coupled directly to the generator rotor in so-called direct drive wind turbines. Or the wind turbine rotor may include a main rotor shaft (a so-called "low speed shaft") which leads to a gearbox. A high-speed shaft of the gearbox may then drive the generator. Regardless of the topology of the wind turbine, the electrical power output of the generator may be fed to an electric grid. The connection of the generator to the grid may include e.g. a converter, transformer, medium voltage line and other.

Wind turbines further typically comprise a power electronic converter for converting electrical power generated by the generator to a converted AC ("Alternating Current") power of predetermined frequency and voltage. The converted AC power is then supplied to a main wind turbine transformer having a low voltage side and a high voltage side for transforming the converted AC power to a higher voltage and delivering the power to the grid.

Different topologies for wind turbine generators and power electronic converters are known. One such topology is a DFIG ("Doubly Fed Induction Generator"). In the DFIG configuration, a stator of the generator is directly connected to the grid. The rotor of the generator comprises a plurality of coils. These coils are electrically connected to the grid through a power electronic converter comprising a rotor side converter, a DC-link, and a grid side converter.

In another known topology, the rotor of the generator carries a plurality of permanent magnets. The stator of the generator is connected to the grid through a so-called "full converter". The full converter includes a machine side converter, a DC-link, and a grid side converter.

Power converters may include different switches and rectifiers including diodes and semiconductor devices such as IGBT's (Insulated Gate Bipolar Transistor), MOSFET's (metal-oxide-semiconductor field-effect transistor) and thyristors.

A power semiconductor device may herein be regarded as a semiconductor device used as a switch or rectifier in power electronics. Such a device may also be called a "power device".

A wind turbine further typically comprises a wind turbine controller. The wind turbine controller may be configured to determine suitable actuator setpoints for the wind turbine based on the prevailing circumstances. The actuator setpoints for modern variable speed wind turbines include e.g. the generator torque and the pitch angle of the blades. Through control of the pitch angle(s) of the blade(s) and the generator torque, the speed of the rotor may be controlled, as well as the electrical power output, aerodynamic thrust and further mechanical loads. The purpose of the control system is generally to maximize electrical power output while at the same time keeping loads in the wind turbine at an acceptable level.

Normal or standard operation of a wind turbine may generally be along a predefined power curve, which prescribes the operation of the wind turbine as a function of the prevailing wind speed. Normal operation includes different operational ranges. In lower wind speed ranges, the objective is generally to maximize electrical power output. In higher wind speed ranges, particularly wind speeds above nominal wind speed, the operation of the wind turbine is focused on keeping loads under control, while maintaining electrical power output at a predetermined level.

As mentioned before, the actuator setpoints of torque and pitch (but also other actuators such as yaw) may be changed in accordance with circumstances. Such circumstances may include e.g. the average wind speed, turbulence, wind shear, air density and other meteorological conditions but also internal conditions like vibrations, mechanical loading or component temperatures etc. They may also include specific external demands to reduce noise, an interruption of operation for maintenance, grid based situations of e.g. demand of reduction of active power, or a grid event such as a low voltage event, a zero voltage event, an increase in grid frequency or other.

Depending on the operational situation of a wind turbine, the setpoints from the wind turbine controller, and the electrical power output of the generator, the currents in the power converter and its components may vary.

When a power device is subjected to a current, the chip will heat up due to the internal losses in the chip. Semiconductors are formed of materials with different thermal expansion coefficients (such as silicon chip, copper heat dissipating plate, plastic case and silicon gel), so repetition of thermal expansion and contraction causes thermal stresses in these materials, which can result in disconnection of aluminium bonding wires and cracks in solder, which in turn leads to destruction of the power semiconductors. This phenomenon is called a power cycle. This can lead to degeneration of the chip, bondwire liftoffs or any other degeneration or wearout of the power device.

The temperature of the chip and the variation of the temperature is important for the performance, and reliability of the chip. The temperature and temperature changes also have an important impact on the degradation of the chip and the end of lifetime of a chip accommodated in a power device. Therefore, it would be beneficial to measure or otherwise monitor the temperature directly. However, direct observation of temperature can be challenging or even impossible particularly when an electric drive system is in service in the field.

Life of a power device in a power converter changes depending on environmental conditions, such as wind speed (which is inherently variable), and ambient air temperature, and therefore it is not easy to predict the accumulated life usage accurately. When the life usage of a power device cannot be predicted accurately, the operator may miss the timing for replacement of a power device, which may result in a decline in operating efficiency and even a serious accident. In addition, it may result in unnecessary replacement of a power device.

Identifying power converter fleet aging and putting in place predictive maintenance capabilities will ensure the best availability of the turbines. Particularly in the case of offshore turbines, maintenance is preferably planned well in advance because special vessels are generally required. The predictability of issues for converters can permit a better and early planning of the vessel operations and can thus have a significant impact on cost savings.

It is known in the art to estimate junction temperature using high frequency sampling data, particularly phase current and voltage drop. Based on these the junction temperature is calculated or estimated. However, it has been found that such estimates or calculations do not necessarily lead to a well-informed decision-making process. In the prior art, the high frequency data may be used for life prediction based on rain cycle counting. However, for wind turbines from other vendors or other wind fleet without these life predictors, the service and maintenance team face significant challenges to do inventory and plan servicing.

Therefore, there is a need to provide estimates of the junction temperature and life usage for power semiconductor with low frequency sampling data. There is a further need to improve a decision-making process relating to maintenance or repair of power converters, and regarding substitution of its components.

There is also a need to be able to predict remaining life using low frequency sampling data.

Most existing reliability models are deterministic. However, a point estimate stating that the converter will fail in 30 days may not be sufficient to schedule a replacement/repair. Repair timing may be more easily scheduled using time intervals.

Examples of the present disclosure provide systems and methods that at least partially resolve one or more of the aforementioned problems.

Even though the present disclosure focuses on power semiconductor devices used in power converters of wind turbines, similar problems may be found in power semiconductor devices in other applications. The present disclosure is therefore not limited to applications in wind turbines.

### SUMMARY

In a first aspect, a method for estimating an operational state of a semiconductor chip of a power semiconductor device is provided. The method comprises receiving operational data related to the semiconductor chip over consecutive time intervals and determining a parameter indicative of an operational state of the semiconductor chip including an indication of uncertainty of the operational state based on the received operational data. The method further comprises generating an alert if an alert criterion is fulfilled, wherein the alert criterion is based on the parameter indicative of the operational state of the semiconductor chip and the indication of uncertainty.

In accordance with this aspect, an uncertainty regarding the operational state is taken into account in order to determine an operational status and in order to generate an alert. Thus, not only a specific value of e.g. peak junction temperature or life usage is taken into account, but rather a possible distribution thereof. An alert may be generated based on e.g. a confidence interval or probability distribution rather than on reaching a specific threshold. The method may be used with data available from low sampling rate.

Operational data herein may be data that is indirectly related to the semiconductor chip. Indirect operational data may herein be regarded as operational data of a machine or apparatus in which the semiconductor chip is used or to which the semiconductor chip is connected, but not operational data (e.g. current or temperature) of the semiconductor chip itself.

An indication of uncertainty may herein be regarded as a measure, variable or parameter indicating that the actual exact state of the semiconductor chip is not known, but rather that different states are possible, and these different states have different probabilities of being the actual exact state.

In a second aspect, a method for predicting remaining useful life of a semiconductor chip accommodated in a power semiconductor device is provided. The method comprises estimating a current state of the semiconductor chip and determining a potential degradation of the semiconductor chip over time as a function of operating conditions of the semiconductor chip. The method further comprises estimating a remaining useful life for the semiconductor chip based on the estimated current state of the semiconductor chip and the potential degradation. In the method, determining the potential degradation comprises selecting an early-life degradation model or an end-of-life degradation model, wherein the early-life degradation model is based on a slower sampling rate than the end-of-life degradation model.

According to this aspect, the predictability of end-of-life for power semiconductor devices may be improved. An improved method which allows for planned retirement, substitution or maintenance is thus provided. The method recognizes that the speed and manner of degradation of the power semiconductor device may be different in early-life than at end-of-life and is configured to take this different degradation behaviour into account.

In any of these aspects, based on the prediction of remaining useful life or based on the estimation of the operational state of the semiconductor chip, operation of the wind turbine and/or the power converter and/or the semiconductor chip may be adjusted.

In further aspects, the present disclosure also relates to computer programs and computer systems which are configured to carry out such methods.

### BRIEF DESCRIPTION OF THE DRAWINGS

Non-limiting examples of the present disclosure will be described in the following, with reference to the appended drawings, in which:
Figure 1 illustrates a perspective view of a wind turbine according to one example;
Figure 2 illustrates a detailed, internal view of a nacelle of a wind turbine according to one example;
Figure 3A schematically illustrates an example of degradation of a power device over its lifetime;
Figure 3B schematically illustrates a first example of a method for estimating an operational state of a semiconductor chip of a power semiconductor device;
Figure 3C schematically illustrates an example of a peak junction temperature of a semiconductor chip with an indication regarding the uncertainty;
Figures 3D and 3E schematically illustrate examples of how a method according to figure 3B may be implemented;
Figure 3F schematically illustrates the use of an ensemble of models to determine an operational state of a semiconductor chip of a power semiconductor device;
Figures 4A and 4B schematically illustrate examples of methods for estimating an operational state of a semiconductor chip of a power semiconductor device in a power converter coupled to a wind turbine generator;
Figure 4C schematically illustrates an example of a user interface that may be used in examples of methods for determining an operational status of a semiconductor chip;
Figure 5A schematically illustrates an example of estimating a remaining useful life for a semiconductor chip; and
Figures 5B schematically illustrates how examples of the methods of figure 5A may be combined with examples of the methods of figures 3 and 4.

### DETAILED DESCRIPTION OF EXAMPLES

Reference now will be made in detail to embodiments of the disclosure, one or more examples of which are illustrated in the drawings. Each example is provided by way of explanation only, not as a limitation. In fact, it will be apparent to those skilled in the art that various modifications and variations can be made in the present disclosure without departing from the scope or spirit. For instance, features illustrated or described as part of one embodiment can be used with another embodiment to yield a still further embodiment. Thus, it is intended that the present disclosure covers such modifications and variations as come within the scope of the appended claims and their equivalents.

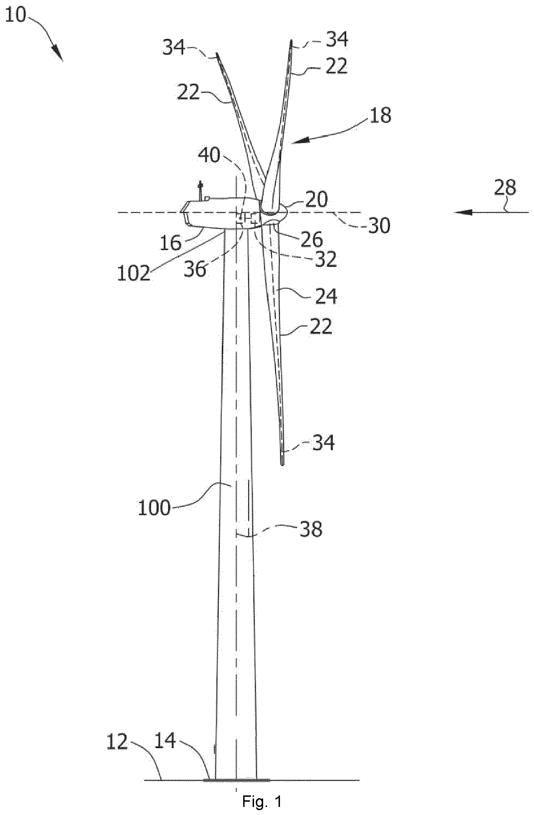

FIG. 1 is a perspective view of an example of a wind turbine 10. In the example, the wind turbine 10 is a horizontal-axis wind turbine. Alternatively, the wind turbine 10 may be a vertical-axis wind turbine. In the example, the wind turbine 10 includes a tower 100 that extends from a support system 14 on a ground 12, a nacelle 16 mounted on tower 100, and a rotor 18 that is coupled to nacelle 16. The rotor 18 includes a rotatable hub 20 and at least one rotor blade 22 coupled to and extending outward from the hub 20. In the example, the rotor 18 has three rotor blades 22. In an alternative embodiment, the rotor 18 includes more or less than three rotor blades 22. The tower 100 may be fabricated from tubular steel to define a cavity (not shown in Figure 1) between a support system 14 and the nacelle 16. In an alternative embodiment, the tower 100 is any suitable type of a tower having any suitable height. According to an alternative, the tower can be a hybrid tower comprising a portion made of concrete and a tubular steel portion. Also, the tower can be a partial or full lattice tower.

The rotor blades 22 are spaced about the hub 20 to facilitate rotating the rotor 18 to enable kinetic energy to be transferred from the wind into usable mechanical energy, and subsequently, electrical energy. The rotor blades 22 are mated to the hub 20 by coupling a blade root portion 24 to the hub 20 at a plurality of load transfer regions 26. The load transfer regions 26 may have a hub load transfer region and a blade load transfer region (both not shown in Figure 1). Loads induced to the rotor blades 22 are transferred to the hub 20 via the load transfer regions 26.

In examples, the rotor blades 22 may have a length ranging from about 15 meters (m) to about 90 m or more. Rotor blades 22 may have any suitable length that enables the wind turbine 10 to function as described herein. For example, non-limiting examples of blade lengths include 20 m or less, 37 m, 48.7 m, 50.2m, 52.2 m or a length that is greater than 91 m. As wind strikes the rotor blades 22 from a wind direction 28, the rotor 18 is rotated about a rotor axis 30. As the rotor blades 22 are rotated and subjected to centrifugal forces, the rotor blades 22 are also subjected to various forces and moments. As such, the rotor blades 22 may deflect and/or rotate from a neutral, or non-deflected, position to a deflected position.

Moreover, a pitch angle of the rotor blades 22, i.e., an angle that determines an orientation of the rotor blades 22 with respect to the wind direction, may be changed by a pitch system 32 to control the load and power generated by the wind turbine 10 by adjusting an angular position of at least one rotor blade 22 relative to wind vectors. Pitch axes 34 of rotor blades 22 are shown. During operation of the wind turbine 10, the pitch system 32 may particularly change a pitch angle of the rotor blades 22 such that the angle of attack of (portions of) the rotor blades are reduced, which facilitates reducing a rotational speed and/or facilitates a stall of the rotor 18.

In the example, a blade pitch of each rotor blade 22 is controlled individually by a wind turbine controller 36 or by a pitch control system 80. Alternatively, the blade pitch for all rotor blades 22 may be controlled simultaneously by said control systems.

Further, in the example, as the wind direction 28 changes, a yaw direction of the nacelle 16 may be rotated about a yaw axis 38 to position the rotor blades 22 with respect to wind direction 28.

In the example, the wind turbine controller 36 is shown as being centralized within the nacelle 16, however, the wind turbine controller 36 may be a distributed system throughout the wind turbine 10, on the support system 14, within a wind farm, and/or at a remote control center. The wind turbine controller 36 includes a processor 40 configured to perform the methods and/or steps described herein. Further, many of the other components described herein include a processor.

As used herein, the term "processor" is not limited to integrated circuits referred to in the art as a computer, but broadly refers to a controller, a microcontroller, a microcomputer, a programmable logic controller (PLC), an application specific, integrated circuit, and other programmable circuits, and these terms are used interchangeably herein. It should be understood that a processor and/or a control system can also include memory, input channels, and/or output channels.

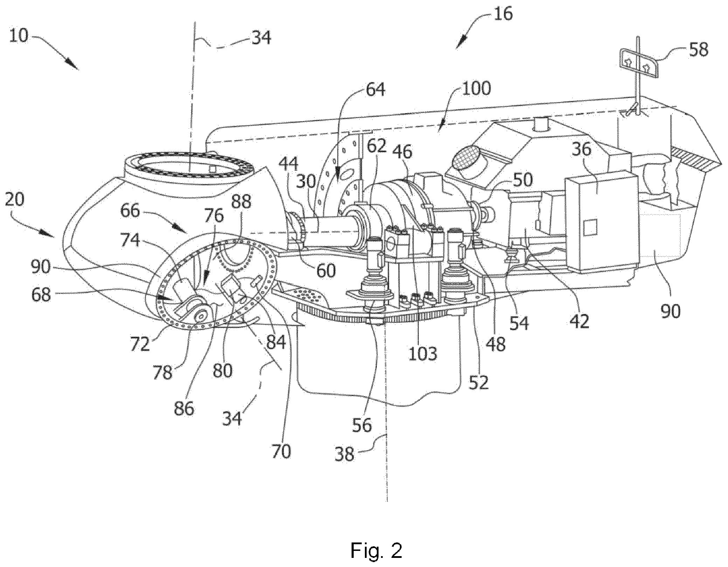

FIG. 2 is an enlarged sectional view of a portion of the wind turbine 10. In the example, the wind turbine 10 includes the nacelle 16 and the rotor 18 that is rotatably coupled to the nacelle 16. More specifically, the hub 20 of the rotor 18 is rotatably coupled to an electric generator 42 positioned within the nacelle 16 by the main shaft 44, a gearbox 46, a high-speed shaft 48, and a coupling 50. In the example, the main shaft 44 is disposed at least partially coaxial to a longitudinal axis (not shown) of the nacelle 16. A rotation of the main shaft 44 drives the gearbox 46 that subsequently drives the high-speed shaft 48 by translating the relatively slow rotational movement of the rotor 18 and of the main shaft 44 into a relatively fast rotational movement of the high-speed shaft 48. The latter is connected to the generator 42 for generating electrical energy with the help of a coupling 50. Furthermore, a transformer 90 and/or suitable electronics, switches, and/or inverters may be arranged in the nacelle 16 in order to transform electrical energy generated by the generator 42 having a voltage between 400V to 1000 V into electrical energy having medium voltage (10 - 35 KV) or higher voltage, e.g. 66kV. Said electrical energy is conducted via power cables 160 from the nacelle 16 into the tower 100.

The gearbox 46, generator 42 in transformer 90 may be supported by a main support structure frame of the nacelle 16, optionally embodied as a main frame 52. The gearbox 46 may include a gearbox housing that is connected to the main frame 52 by one or more torque arms 103. In the example, the nacelle 16 also includes a main forward support bearing 60 and a main aft support bearing 62. Furthermore, the generator 42 can be mounted to the main frame 52 by decoupling support means 54, in particular in order to prevent vibrations of the generator 42 to be introduced into the main frame 52 and thereby causing a noise emission source.

Optionally, the main frame 52 is configured to carry the entire load caused by the weight of the rotor 18 and components of the nacelle 16 and by the wind and rotational loads, and furthermore, to introduce these loads into the tower 100 of the wind turbine 10. The rotor shaft 44, generator 42, gearbox 46, high speed shaft 48, coupling 50, and any associated fastening, support, and/or securing device including, but not limited to, support 52, and forward support bearing 60 and aft support bearing 62, are sometimes referred to as a drive train 64.

The nacelle 16 also may include a yaw drive mechanism 56 that may be used to rotate the nacelle 16 and thereby also the rotor 18 about the yaw axis 38 to control the perspective of the rotor blades 22 with respect to the wind direction 28.

For positioning the nacelle 16 appropriately with respect to the wind direction 28, the nacelle 16 may also include at least one meteorological measurement system which may include a wind vane and anemometer. The meteorological measurement system 58 can provide information to the wind turbine controller 36 that may include wind direction 28 and/or wind speed. In the example, the pitch system 32 is at least partially arranged as a pitch assembly 66 in the hub 20. The pitch assembly 66 includes one or more pitch drive systems 68 and at least one sensor 70. Each pitch drive system 68 is coupled to a respective rotor blade 22 (shown in Figure 1) for modulating the pitch angel of a rotor blade 22 along the pitch axis 34. Only one of three pitch drive systems 68 is shown in Figure 2.

In the example, the pitch assembly 66 includes at least one pitch bearing 72 coupled to hub 20 and to a respective rotor blade 22 (shown in FIG. 1) for rotating the respective rotor blade 22 about the pitch axis 34. The pitch drive system 68 includes a pitch drive motor 74, a pitch drive gearbox 76, and a pitch drive pinion 78. The pitch drive motor 74 is coupled to the pitch drive gearbox 76 such that the pitch drive motor 74 imparts mechanical force to the pitch drive gearbox 76. The pitch drive gearbox 76 is coupled to the pitch drive pinion 78 such that the pitch drive pinion 78 is rotated by the pitch drive gearbox 76. The pitch bearing 72 is coupled to pitch drive pinion 78 such that the rotation of the pitch drive pinion 78 causes a rotation of the pitch bearing 72.

Pitch drive system 68 is coupled to the wind turbine controller 36 for adjusting the pitch angle of a rotor blade 22 upon receipt of one or more signals from the wind turbine controller 36. In the example, the pitch drive motor 74 is any suitable motor driven by electrical power and/or a hydraulic system that enables pitch assembly 66 to function as described herein. Alternatively, the pitch assembly 66 may include any suitable structure, configuration, arrangement, and/or components such as, but not limited to, hydraulic cylinders, springs, and/or servomechanisms. In certain embodiments, the pitch drive motor 74 is driven by energy extracted from a rotational inertia of hub 20 and/or a stored energy source (not shown) that supplies energy to components of the wind turbine 10.

The pitch assembly 66 may also include one or more pitch control systems 80 for controlling the pitch drive system 68 according to control signals from the wind turbine controller 36, in case of specific prioritized situations and/or during rotor 18 overspeed. In the example, the pitch assembly 66 includes at least one pitch control system 80 communicatively coupled to a respective pitch drive system 68 for controlling pitch drive system 68 independently from the wind turbine controller 36. In the example, the pitch control system 80 is coupled to the pitch drive system 68 and to a sensor 70. During normal operation of the wind turbine 10, the wind turbine controller 36 may control the pitch drive system 68 to adjust a pitch angle of rotor blades 22.

According to an embodiment, a power supply 84, for example comprising a battery, electric capacitors hence letter or an electrical generator driven by the rotation of the hub 20, is arranged at or within the hub 20 and is coupled to the sensor 70, the pitch control system 80, and to the pitch drive system 68 to provide a source of power to these components. In the example, the power supply 84 provides a continuing source of power to the pitch assembly 66 during operation of the wind turbine 10. In an alternative embodiment, power supply 84 provides power to the pitch assembly 66 only during an electrical power loss event of the wind turbine 10. The electrical power loss event may include power grid loss or dip, malfunctioning of an electrical system of the wind turbine 10, and/or failure of the wind turbine controller 36. During the electrical power loss event, the power supply 84 operates to provide electrical power to the pitch assembly 66 such that pitch assembly 66 can operate during the electrical power loss event.

In the example, the pitch drive system 68, the sensor 70, the pitch control system 80, cables, and the power supply 84 are each positioned in a cavity 86 defined by an inner surface 88 of hub 20. In an alternative embodiment, said components are positioned with respect to an outer surface of hub 20 and may be coupled, directly or indirectly, to outer surface.

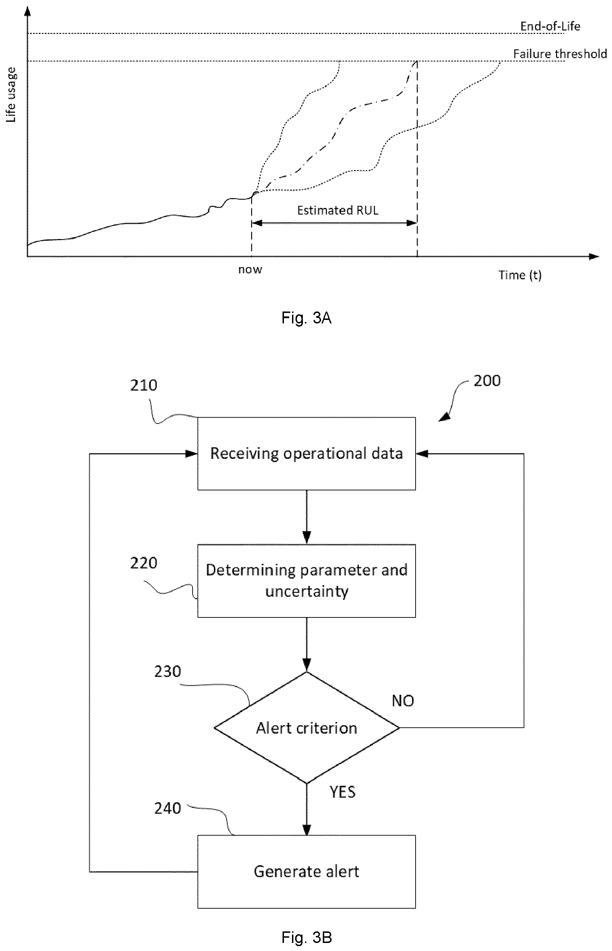

Figure 3A schematically illustrates an example of a possible degradation of a power device over its lifetime. The power device may be a power device in a power converter connected to a wind turbine generator.

A power device may have an expected maximum service life. However, the rate at which a power device degrades will depend on the operation of the power device, and may particularly depend on the levels of current and the related thermal cycling. In order to avoid failure of an apparatus (e.g. power converter) in which the power device is used, the end-of-life (EOL) or the moment at which the power device should be retired or substituted may be estimated or calculated. The EOL herein indicates the moment at which the power device fails to function according to its specifications. A threshold may be defined below the EOL to make sure that failure is avoided.

In figure 3A, at time t = 0, the life of the power device starts. After some time, a first degradation of the performance of the power device may be detected. The moment in time "now" indicates the current moment. Based on different measurements and detections of operational parameters, the remaining useful life (RUL) may be calculated. However, since there is uncertainty both in the measurements of operational parameters (due to the operational parameters that are or can be measured, the sampling rate and/or due to inherent inaccuracies in measurement) and in the rate and manner of degradation as exhibited by the power device, it is possible that the real or actual remaining useful life is shorter or longer than calculated.

Examples of methods and systems of the present disclosure aim to improve decision making regarding retiring, repairing or substituting power devices or apparatus incorporating such power devices by taking into account such uncertainties.

In a first aspect, a method 200 for estimating an operational state of a semiconductor chip of a power semiconductor device is provided. The method 200 comprises, at block 210, receiving operational data related to the semiconductor chip over consecutive time intervals. The operational data may be operational data that is indirectly related to the semiconductor chip, e.g. parameters or variables measured or derived that is not directly obtained from the power semiconductor device.

The method then comprises, at block 220, determining a parameter indicative of an operational state of the semiconductor chip including an indication of uncertainty of the operational state based on the received indirect operational data. And the method further comprises, at block 240, generating an alert if an alert criterion (evaluated at block 230) is fulfilled, wherein the alert criterion is based on the parameter indicative of the operational state of the semiconductor chip and the indication of uncertainty.

In examples, the consecutive time intervals may be between 1 minute and 20 minutes, specifically between 5 and 15 minutes.

As may be seen in the example of figure 3B, the methods as illustrated herein may be continuously executed. I.e. if an alert criterion at block 230 is not fulfilled, the method returns to block 210. Also, if an alert criterion at block 230 is fulfilled, and an alert is generated at block 240, the method may return to block 210. The method may not only be continuously executed, also several loops of the method may run in parallel. I.e. before one loop is finished, another loop may have started.

In some examples, the parameter indicative of the operational state of the semiconductor chip is a peak junction temperature. Peak junction temperature may herein be regarded as the highest operating temperature of the actual semiconductor in an electronic device. High junction temperatures can damage or degrade a semiconductor. The temperature is important for the performance, reliability and end of lifetime of a chip accommodated in a power device. Herein, both maximum temperatures as well as temperature changes may be important.

Direct observation or measurements of temperature can be very challenging or impossible. The prior art teaches using high frequency sampling data e.g. phase current and voltage drop, to derive or estimate a peak junction temperature. Such high frequency data may not necessarily be available. Moreover, the determination of peak junction temperature in this manner can never be 100% precise, i.e. there remains a level of uncertainty even if such high frequency data is available.

The example of figure 3B therefore incorporates in an alert criterion not only a value for the temperature but also an indicator of the uncertainty of the temperature. In some examples, the value and the indication of the uncertainty of the operational state may include two or more of the following indicators regarding a parameter indicative of the operational state (in this case peak junction temperature): mean value, standard deviation, variance, a lower and higher bound with a confidence interval, a minimum, a maximum, a median, a quantile and an interquartile range of the parameter.

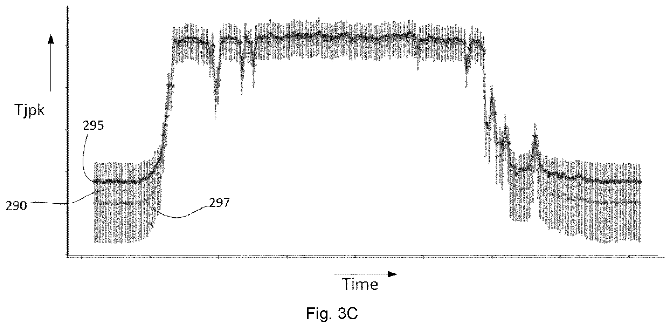

Figure 3C schematically illustrates how for each period (e.g. 10 minutes), not only a mean or average peak junction temperature may be determined, but also an indication of the uncertainty (e.g. confidence interval, standard deviations, multiple of standard deviations, or other) of the peak junction temperature. The line 290 and line 295 represent the point estimates of the peak junction temperature from two independent models, while the line 297 represents the mean peak junction temperature with a 95% confidence interval. Note that the line 297 and its valies correspond to the output of block 220 of figure 2A. Note that the two independent point estimates of the peak junction temperature are covered within the confidence interval output from line 297 in this example.

In an example, the alert criterion may be a higher bound of a 95% confidence interval of the peak junction temperature reaching a specific threshold. If the alert criterion is fulfilled, an alert may be generated. In some examples, the alert criterion may be a predetermined number of times (e.g. three or five or ten or any suitable number) that a higher bound of the peak junction temperature exceeds a predefined temperature threshold.

An alert may take variety of suitable forms. It may be e.g. an alarm message or signal at a user interface. Such a user interface may be arranged e.g. at a remote operating centre. From such a remote operating centre, a plurality of wind turbines, and even a plurality of wind farms may be monitored. An operator may take note of such an alert. And if necessary, operation of a wind turbine or power converter may be adjusted based on the alert.

The user interface may be a graphical user interface. The alert may be in the form of a graph, diagram, text message, table or any other suitable form. The alerts may additionally or alternatively be audible.

In some examples, the parameter indicative of the operational state of the semiconductor chip may be a life usage of the chip, and optionally may be an accumulated life usage of the chip, or a life usage rate of the chip. Instead of the peak junction temperature or in addition to the peak junction temperature, also life usage of the chip may be used for generating an alert. In particular, a threshold may be defined in relation with accumulated life usage or life usage rate.

Life usage may herein be regarded as "life consumption", the amount (e.g. percentage) of the life of the semiconductor chip that is used up in a given time frame ("life usage rate"), or has been used up until a given point in time (accumulated life consumption or accumulated life usage).

In some examples, the alert criterion for life usage may be that a difference between a high bound of cumulative life usage and a low bound of cumulative life usage for a certain time period exceeds a predefined life usage threshold. The difference between the high bound at the end of a time period and the low bound at the beginning of a time period is an indicator of a deterioration rate.

Alerts may be generated at a machine level e.g. at a power converter level or wind turbine level. Alerts may also be generated at the level of individual phase modules. E.g. when either peak junction temperature or cumulative life usage of a semiconductor chip of an individual phase module complies with an alert criterion, the specific individual phase module may be identified at the user interface. An operator may thus know not only overall degradation or life usage at the converter level, but rather also at an individual phase module level.

In examples, a parameter indicative of the operational state of the semiconductor chip may be based on a life usage or peak temperature of one or more of a transistor, a diode, a heat sink or a capacitor.

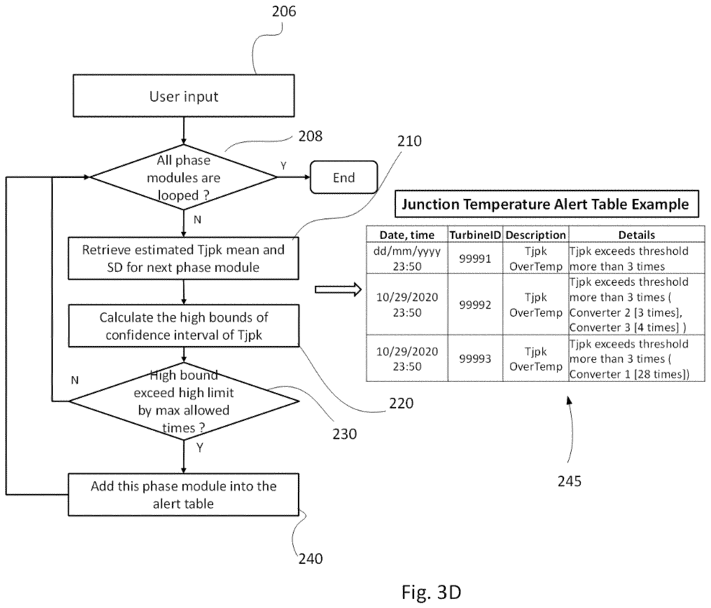

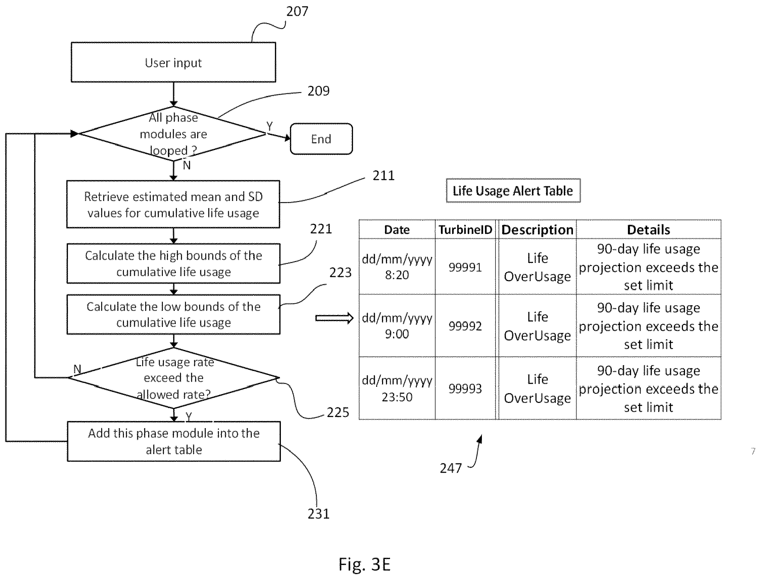

Figures 3D and 3E schematically illustrate examples of how a method according to figure 3B may be implemented. Figure 3D schematically illustrates a method of determining a peak junction temperature. At block 206, user input may be obtained. The user input may include e.g. retrieval time duration, phase modules of interest, temperature thresholds and maximum number of times that the temperature threshold may be reached (e.g. within a given time period).

A phase module is herein to be regarded as the converter module of a given electrical phase or group of phases of a wind turbine generator.

At block 208, a determination may be made whether all relevant phase modules are looped in. At block 210, the mean peak junction temperature, and standard deviation may be obtained for a phase module. Based on the mean peak junction temperature and the standard deviation, a confidence interval (e.g. 90 or 95% confidence interval) for the peak junction temperature may be determined. The high bound of the confidence interval may be compared, at block 230, with the temperature threshold. If the high bound of the confidence interval exceeds the temperature threshold, the specific phase module may be added to the alert table 245.

The alert table 245 in this example includes a timestamp (date, time) of an event, as well as an ID or identifier of the wind turbine in question, and a description of the event.

The method may then continue to the next phase module.

Figure 3E shows a similar example for a method of determining a life usage of a semiconductor chip. At block 207, user input may be obtained. The user input may include e.g. retrieval time duration, phase modules of interest, and maximum allowed life usage rate. At block 209, it may be checked whether all relevant phase modules are looped in.

At block 211, an estimated mean accumulated life usage may be determined for the power devices in a phase module, as well as the standard deviation of the accumulated life usage. At blocks 221, and 223, the high bounds of the accumulated life usage at the end of the period and the low bounds of the accumulated life usage at the beginning of the period may be determined. From these two, a life usage rate may be determined. If the life usage rate is above a threshold for life usage rate, the phase module in question may be added to the alert table 247.

Similarly as for the previous example, the alert table 247 in this example includes a timestamp, an identification of the wind turbine in question and a description of the corresponding event. In both the examples of tables 245 and 247, instead of identification at a wind turbine level, identification may also be at the level of an individual phase module.

The method may then continue to the next phase module.

In examples, determining the parameter indicative of an operational state of the semiconductor chip including the indication of uncertainty of the operational state based on the received operational data comprises determining the operational state of the semiconductor chip with an ensemble of models estimating the operational state of the semiconductor chip.

Ensemble modeling is a process where multiple diverse models are created to predict an outcome, either by using many different modeling algorithms or using different training data sets. The ensemble model may then aggregate the prediction of each base model and results in a final prediction. Such a final prediction may include a particular value and an indication of the uncertainty.

The ensemble of models may be an implicit ensemble or an explicit ensemble. An explicit ensemble may have multiple values of the state distribution and an aggregation of the multiple values may be conducted as a post processing step. Implicit ensemble may have multiple ensemble models inside one model, and the aggregation step is self-contained in the same model.

In other examples, determining the parameter indicative of an operational state of the semiconductor chip including the indication of uncertainty of the operational state based on the received operational data comprises determining the operational state of the semiconductor chip with Bayesian inference model.

In these examples, the Bayesian inference model may be a stochastic artificial neural network trained using Bayesian inference, wherein an activation function and/or weights in the artificial neural network may be stochastic with an associated probability distribution.

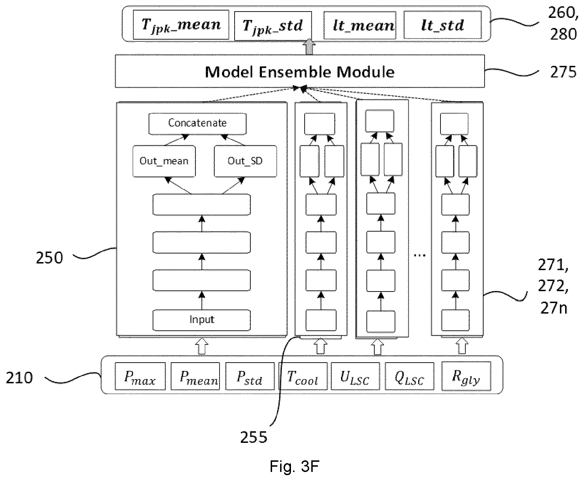

Figure 3F schematically illustrates the use of an ensemble of models to determine an operational state of a semiconductor chip of a power semiconductor device.

At block 210, operational parameters of the wind turbine generator and/or converter are obtained e.g. at a 10 minute sampling rate. The operational parameters in this example may include maximum power output (Pₘₐₓ), mean power output (Pₘₑₐₙ), standard deviation of power output (P_{std}), temperature of the coolant of the power converter, voltage at the line side converter (ULSC), reactive power at the line side converter (Q_{LSC}). Further input may be a percentage of glycol as part of the coolant (R_{gly}).

Based on these parameters, the mean peak junction temperature and standard deviation of the of the peak junction temperature may be calculated with a first model 250. Similarly, with a different model 255 (and with further models) mean value and standard deviation for the peak junction temperatures may be calculated. Based on the outcomes of the different models of the model ensemble, at block 260, a mean and standard deviation of the peak junction temperature may be obtained from the model ensemble module 275.

Similarly, an ensemble of models 271, 272, ...27n may be used to determine a mean value and standard deviation for the life usage.

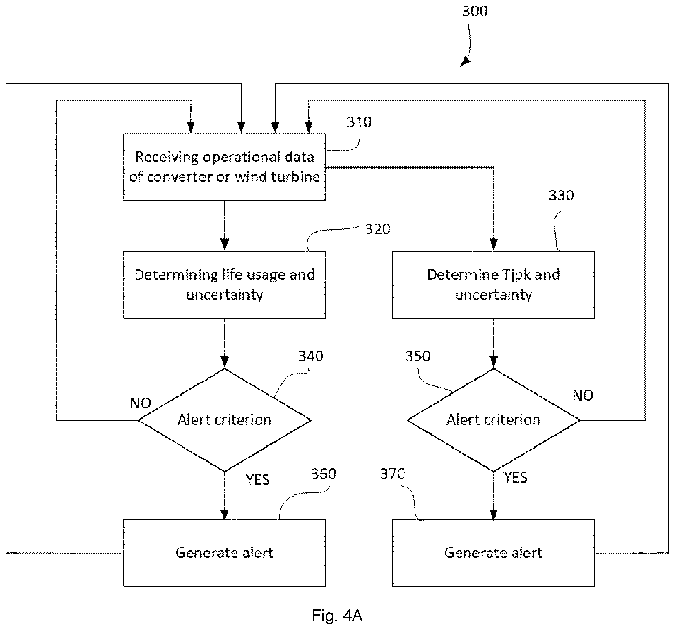

Figure 4A illustrates an example of a method for estimating an operational state of a semiconductor chip of a power semiconductor device, wherein the power semiconductor device is a power semiconductor device in a power converter of a wind turbine connected to an electrical grid.

As in figure 3B, the method may comprise, at block 310, receiving operational data indirectly related to the semiconductor chip over consecutive time intervals. In this particular case, the operational data may be operational data of the power converter or of the wind turbine.

In some examples, the operational data may include one or more of maximum active power of a generator during a time interval, mean active power of the generator during the time interval, standard deviation of active power of the generator, coolant temperature of the converter, mean voltage at the wind turbine and mean reactive power delivered to the grid. Other or further operational data may also be used.

In general, indirect operational data that can be indicative of current levels in the power semiconductor devices may be used. The data mentioned above is typically already available from the wind turbine anyway i.e. these operational data are measured or registered for other purposes including control of the wind turbine, or control of a wind farm. In examples, the consecutive time intervals for obtaining these operational data (the sampling rate) may be between 1 minute and 20 minutes, specifically between 5 and 15 minutes. Most of the aforementioned operational data mentioned before may be measured e.g. in 10 minute time intervals.

In the example of figure 4A, based on such operational data, both peak junction temperature and life usage, and accompanying uncertainty may be determined at blocks 320 and 330. Uncertainty may herein again be any indicator of a potential distribution, including confidence intervals, variance, standard deviations etc.

In the example of figure 4A, independent alert criterions may be defined both for the life usage at 340, and for the peak junction temperature at 350. If one of these alert criterions or both alert criterions are fulfilled, an alert may be generated at 360, and 370 respectively.

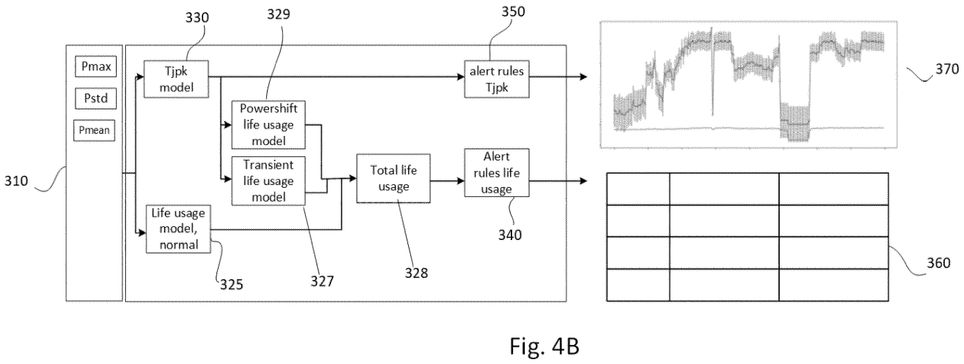

Figure 4B illustrates an example of how a method of figure 4A may be implemented. In figure 4B, with ten minute intervals, operational parameters which may be the same or similar as the ones of figure 3F, may be obtained from the wind turbine, and particularly the wind turbine generator, and of the power electronic converter which is connected between the generator and an electrical grid: e.g. maximum power output (Pₘₐₓ), mean power output (Pₘₑₐₙ), standard deviation of power output (P_{std}), temperature of the coolant of the power converter, voltage at the line side converter (U_{LSC}), reactive power at the line side converter (Q_{LSC}). Further input may be a percentage of glycol as part of the coolant (R_{gly}).

Based on these operational data, peak junction temperature including an indication of uncertainty (or possible distribution of peak junction temperature), output of block 330, may be derived as shown in block 370. Meanwhile, life usage including an indication of uncertainty, output of block 325, may also be derived.

Uncertainty regarding the life usage may be propagated to determine an accumulated life usage. I.e. individual determinations of life usage or (life usage rate) including the uncertainty distribution of life usage may be taken into account to determine an accumulated life usage (with its own uncertainty distribution).

The uncertainty of the cumulative life usage may be propagated from the uncertainty for the life usage and/or junction temperature estimate, wherein the uncertainty propagation may use a first order derivative approach or a Monte-Carlo simulation approach.

In examples, the cumulative life estimation may comprise a life resetting module to reset life usage value to zero when the power semiconductor device is replaced. If an individual power semiconductor device is substituted for a new one, then its accumulated life usage will be zero again. Such a reset may occur at the level of individual power semiconductor devices.

As illustrated in figure 4B, the accumulated life usage at block 328 may differentiate and take into account different types of events. On the one hand "normal" or standard operation will lead to a specific usage at block 325. On the other hand, non-standard situations can have a significant impact on the life usage. Non-standard situations may e.g. include transients, such as e.g. grid events involving voltage dip, voltage sags and other. At block 327, a specific life usage model (or ensemble of models) may be used to determine a life usage based on the occurrence of a transient. Input for the transient life usage model may come from the determination of the peak junction temperature at block 330.

Similarly, a specific model (or specific models) may be used to determine life usage (or life usage rate) for power shift events at block 329. Power shift events may herein be regarded as transients in which an electrical power output, under the control of the power converter, changes in response to a change in wind speed. The input for the model of these power shift events may also include the peak junction temperature at block 330.

At block 350, alerts may be generated in relation with the peak junction temperature of a semiconductor chip, and at block 340, alerts may be generated relating to life usage. The alerts may include e.g. an alert table 360 related to the life usage, and/or a diagram showing peak junction temperature variation over time for a specific semiconductor chip (or phase module).

Based on the determination of the accumulated life usage, an estimate of the remaining useful life (RUL) may be made. The RUL may include a mean value and an indication of uncertainty. Quantifying the accuracy of the prediction of the reliability index (failure rate) may be as important as the prediction itself. As mentioned before, a point estimate stating that the converter will fail in 30 days may not be sufficient to schedule a replacement/repair. However, given a prediction interval of 45-60 days with 99% probability, the repair timing may be more easily scheduled.

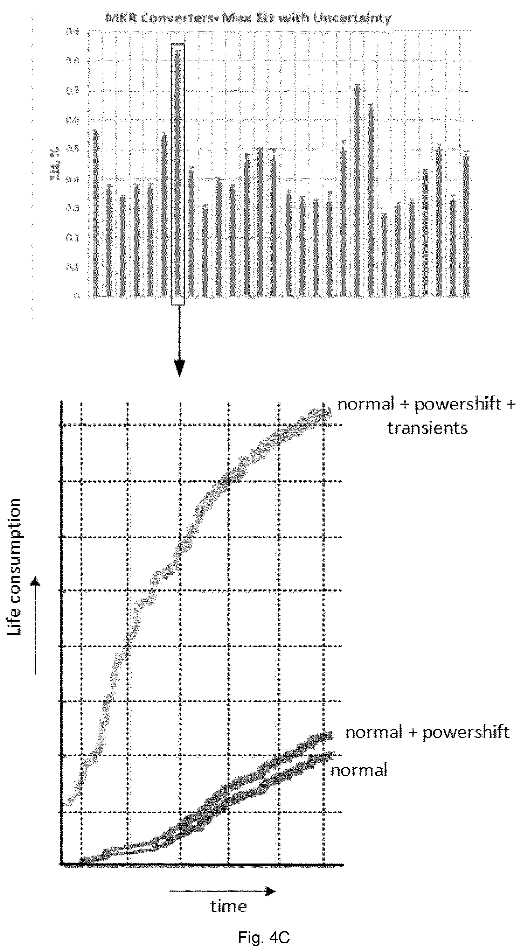

Figure 4C schematically illustrates an example of a graphical user interface that may be used in connection with the methods disclosed herein. A graphical user interface may be hierarchical, and include e.g. information at the level of an entire fleet of wind turbines, or a group of wind turbines, e.g. all wind turbines in a wind farm. In a view of the fleet, all wind turbines of the fleet may be shown, and for the wind turbines, e.g. peak junction temperature (alerts) and accumulated life usage may be shown. A part of the fleet level interface may be seen at the top of figure 4C.

In an example, a user may then select a wind turbine of interest. At individual wind turbine level, information may be shown for each of the converters of the wind turbine (e.g. two or three). A user may then select e.g. a specific converter and retrieve information e.g. about peak junction temperature over the life time or the accumulated life usage and its possible sources.

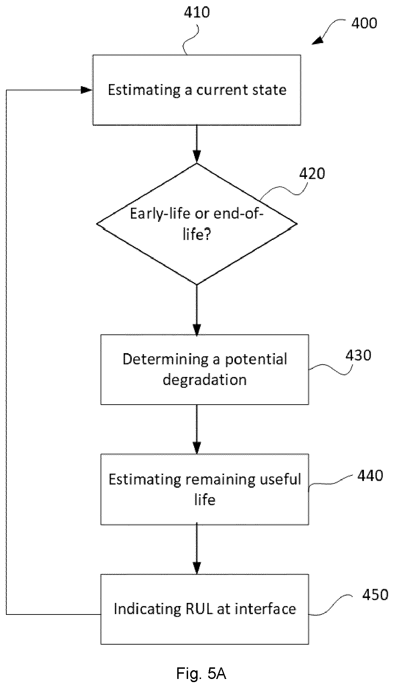

In a further aspect of the present disclosure, a method 400 for predicting remaining useful life of a semiconductor chip accommodated in a power semiconductor device is provided. Such a method is illustrated in figure 5A.

As mentioned with respect to the examples of figures 3 and 4, the power semiconductor device may be a power semiconductor device arranged in a power converter of a wind turbine. However, the methods for predicting remaining useful life may also be used in other apparatus.

The method comprises, at block 410, estimating a current state of the semiconductor chip and determining a potential degradation, at block 430, of the semiconductor chip over time as a function of operating conditions of the semiconductor chip.

The method further comprises, at block 440, estimating a remaining useful life for the semiconductor chip based on the estimated current state of the semiconductor chip and the potential degradation.

Herein, as illustrated in figure 5A, determining the potential degradation comprises, at block 420, selecting an early-life degradation model or an end-of-life degradation model, wherein the early-life degradation model is based on a slower sampling rate than the end-of-life degradation model.

Herein, the current state of the semiconductor chip may particularly indicate the accumulated life usage.

A prognosis of the potential degradation of the semiconductor chip over time may be made as a function of operating conditions of the semiconductor chip. For example, in the case of an implementation in a power converter coupled to a wind turbine generator, the operating conditions of the semiconductor chip may depend e.g. on ambient temperatures, operating conditions of the wind turbine including e.g. wind speed (because they will influence the power output of the generator and thereby the loading of semiconductor chips in the power converter). Based on estimated future loads and environmental exposure, estimates may be made of at what time an IGBT will no longer operate within its stated specifications.

Such an estimate may be made, in some examples, at the level of individual phase modules.

The remaining useful life may include an indication of uncertainty. As in the examples illustrated before, indications of uncertainty may include e.g. mean value, standard deviation, variance, a lower and higher bound with a confidence interval, a minimum, a maximum, a median, a quantile and an interquartile range of the remaining useful life.

For example, an alert of immediate replacement may be generated the if 5% quantile of remaining useful life (RUL) is less than 1 week. An alert to plan replacement may be generated if the 5% quantile of RUL is more than 1 week but less than 3 months. It should be clear that these are mere examples, and different alerts based on different criteria may be configured based on specific needs.

In examples, prognoses may be made based on different scenarios e.g. "good case" or light loading scenarios and on "worst case" of heavy loading scenarios. Such scenarios may individually generate estimations of the remaining useful life.

In examples, the method may further comprise, at block 450, indicating at a user interface the remaining useful life for the semiconductor chip. As mentioned before, the user interface may be provided e.g. at a remote location from the wind turbine and particularly in a remote operating centre monitoring plurality of wind turbines or wind farms. Based on such an indication at the user interface, an operator may take a variety of actions including e.g. plan maintenance taking into account the aging of the whole fleet or at least a significant part of the fleet.

In examples, the end-of-life degradation model may have a sampling rate of between 5 minutes and 2 days for each sample, more specifically between 10 minutes and 1 day. In examples, the early-life degradation model may have a sampling rate of e.g. one week or even more than one week. Different sampling rates may thus be selected based on the stage of life, and in accordance with the needs of monitoring the degradation more closely towards the end of life.

In examples, estimating the accumulated life usage of the semiconductor chip may comprises any of the methods illustrated with reference to figures 3 and 4. In particular, the accumulated life usage of the semiconductor chip may be based on uncertainty based estimation of e.g. life usage at individual moments in time, and the uncertainty may be propagated to determine an estimation of the accumulated life usage and an indication of the uncertainty.

Such estimations may be complemented with inspection-based data.

In examples, the selection of the early-life degradation model or the end-of-life degradation model may be based on a change in trend of the life usage of the semiconductor chip. If a sudden rate of change of deterioration is noted and is noted to persist, this may be a sign to switch to an end-of-life degradation model.

Different events may cause different life usage (rates). E.g. it is known that transients or grid events can cause a relatively large consumption of life time of a semiconductor chip in a wind turbine power converter. If large life consumption occurs in such an event, this is not necessarily a sign of old age for the semiconductor chip. However, if a high life usage rate occurs under normal circumstances, this may be a sign of a trend break and an indicator to switch to end-of-life degradation model.

A decay model may be used to fit the dynamic time evolution of e.g. a phase module health indicator during the degradation process. A decay model may be based on linear fitting. Throughout the lifetime, there may be instances of higher loading, e.g. transients, grid events and other. In such cases, it is expected that life usage is higher than in standard operating conditions.

Use of a decay model may indicate however when a trend of the life usage changes. Based on such a change in trend, the determination may be made that a semiconductor chip does not work anymore as in early-life, but rather as in end-of-life. The sampling rate and degradation model to determine an estimate of remaining useful life may be adapted based on this determination.

In examples, estimating the accumulated life usage of the semiconductor chip may be at least partially based on data from inspection of the power converter. Such an inspection may include e.g. manual inspection. An inspection may reveal that the status of the semiconductor chip is better or worse than assumed based on the measured operational parameters and models used to estimate their status.

In examples, the early-life degradation model and/or the end-of-life degradation model determine degradation and an indication of uncertainty of the potential degradation.

In examples, the end-of-life degradation model and/or the early-life degradation model may be updated based on real life data taking into account similar ambient conditions and/or recency of the real life data. Based on real life data, corrections may be made in the degradation models used to estimate a remaining useful life. The most reliable data may be selected as the data that is based on the most similar ambient conditions as those of power converter or semiconductor chips being monitored. Additionally, data that is more recent may be regarded as more reliable than historical data. Based on the data that may be regarded as more reliable, the degradation models may be updated to render better results.

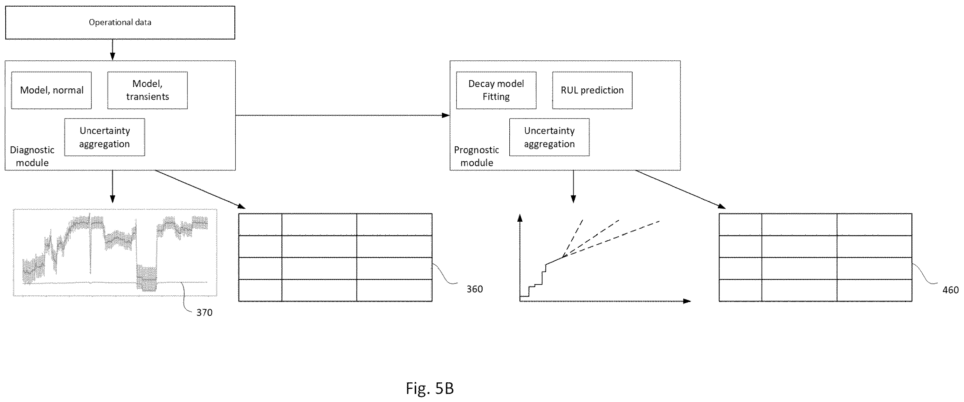

Figure 5B schematically illustrates how methods for determining RUL may be combined with the methods for determining an operational state of a semiconductor chip of the earlier examples.

Examples of the various methods disclosed herein may be implemented with hardware, software, firmware and combinations thereof.

Those of skill in the art would further appreciate that the various illustrative logical blocks, modules, circuits, and algorithm steps described in connection with the disclosure herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application.

The various illustrative logical blocks, modules, and circuits described in connection with the disclosure herein may be implemented or performed with one or more general-purpose processors, a digital signal processor (DSP), cloud computing architecture, an application specific integrated circuit (ASIC), a field programmable gate array (FPGA) or other programmable logic device, discrete gate or transistor logic, discrete hardware components, or any combination thereof designed to perform the functions described herein. A general-purpose processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

The present disclosure also related to computing systems (e.g. data processing apparatus, device or system) adapted to carry out any of the methods disclosed herein. The computing systems adapted to carry out these methods may include dedicated modules for each of the method steps herein described e.g. a "life usage module" to determine life usage including an uncertainty indicator, a "peak junction temperature module" to determine a peak junction temperature including an uncertainty indicator, an "alert criterion" module, an "alert generation" module etc.

The present disclosure also relates to a computer program or computer program product comprising instructions (code), which when executed, performs any of the methods disclosed herein. The present disclosure also relates to computer readable data carrier having stored thereon such a computer program.

The computer program may be in the form of source code, object code, a code intermediate source and object code such as in partially compiled form, or in any other form suitable for use in the implementation of the processes. The carrier may be any entity or device capable of carrying the computer program.

If implemented in software/firmware, the functions may be stored on or transmitted over as one or more instructions or code on a computer-readable medium. Computer-readable media includes both computer storage media and communication media including any medium that facilitates transfer of a computer program from one place to another. A storage media may be any available media that can be accessed by a general purpose or special purpose computer. By way of example, and not limitation, such computer-readable media can comprise RAM, ROM, EEPROM, CD/DVD or other optical disk storage, magnetic disk storage or other magnetic storage devices, or any other medium that can be used to carry or store desired program code means in the form of instructions or data structures and that can be accessed by a general-purpose or special-purpose computer, or a general-purpose or special-purpose processor. Also, any connection is properly termed a computer-readable medium. For example, if the software/firmware is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. Disk and disc, as used herein, includes compact disc (CD), laser disc, optical disc, digital versatile disc (DVD), floppy disk and Blu-ray disc where disks usually reproduce data magnetically, while discs reproduce data optically with lasers. Combinations of the above should also be included within the scope of computer-readable media.

For completeness, a number of aspects of the present disclosure are set out in the following numbered clauses:
Clause 1. A method for estimating an operational state of a semiconductor chip of a power semiconductor device, the method comprising:
   receiving operational data related to the semiconductor chip over consecutive time intervals;
   determining a parameter indicative of an operational state of the semiconductor chip including an indication of uncertainty of the operational state based on the received operational data; and
   generating an alert if an alert criterion is fulfilled, wherein the alert criterion is based on the parameter indicative of the operational state of the semiconductor chip and the indication of uncertainty.
Clause 2. The method according to clause 1, wherein the parameter indicative of the operational state of the semiconductor chip is a peak junction temperature.
Clause 3. The method according to clause 2, wherein the alert criterion comprises a predetermined number of times that a higher bound of the peak junction temperature and the indication of uncertainty thereof exceeds a predefined temperature threshold. Clause 4. The method according to any of clauses 1 - 3, wherein the parameter indicative of the operational state of the semiconductor chip is a life usage of the chip, and optionally is a life usage rate or an accumulated life usage of the chip.
Clause 5. The method according to clause 4, wherein the alert criterion comprises a difference between a high bound of cumulative life usage at the end of a time period and a low bound of cumulative life usage at a beginning of the time period exceeds a predefined life usage threshold.
Clause 6. The method according to clause 4 or 5, wherein the parameter indicative of the operational state of the semiconductor chip is based on a life usage or peak temperature of one or more of a transistor, a diode, a heat sink or a capacitor.
Clause 7. The method according to any of clauses 1 - 6, wherein the power semiconductor device is a power semiconductor device in a power converter of a wind turbine connected to an electrical grid.
Clause 8. The method according to clause 7, wherein the operational data related to the semiconductor chip comprises operational date from the wind turbine and/or the power converter, and optionally comprises one or more of the following: maximum active power of a generator during a time interval, mean active power of the generator during the time interval, standard deviation of active power of the generator, coolant temperature of the converter, mean voltage at the wind turbine and mean reactive power delivered to the grid.
Clause 9. The method according to any of clauses 1 - 8, wherein the indication of the uncertainty of the operational state includes two or more of the following indicators regarding a parameter indicative of the operational state: mean value, standard deviation, variance, a lower and higher bound with a confidence interval, a minimum, a maximum, a median, a quantile and an interquartile range of the parameter.
Clause 10. The method according to any of clauses 1 - 9, wherein determining the parameter indicative of an operational state of the semiconductor chip including the indication of uncertainty of the operational state based on the received operational data comprises determining the operational state of the semiconductor chip with an ensemble of models estimating the operational state of the semiconductor chip.
Clause 11. The method according to any of clauses 1 - 9, wherein determining the parameter indicative of an operational state of the semiconductor chip including the indication of uncertainty of the operational state based on the received operational data comprises determining the operational state of the semiconductor chip with Bayesian inference model, and optionally wherein the Bayesian inference model is stochastic artificial neural network trained using Bayesian inference, wherein an activation function and/or weights in the neural network are stochastic with associated probability distribution.
Clause 12. A method for predicting remaining useful life of a semiconductor chip accommodated in a power semiconductor device, the method comprising:
   estimating a current state of the semiconductor chip, optionally according to any of the methods of any of clauses 1 - 11;
   determining a potential degradation of the semiconductor chip over time as a function of operating conditions of the semiconductor chip;
   estimating a remaining useful life for the semiconductor chip based on the estimated current state of the semiconductor chip and the potential degradation, wherein
   determining the potential degradation comprises selecting an early-life degradation model or an end-of-life degradation model, wherein the early-life degradation model is based on a slower sampling rate than the end-of-life degradation model.
Clause 13. The method according to clause 12, wherein the selection of the early-life degradation model or the end-of-life degradation model is based on a change in trend of the life usage of the semiconductor chip.
Clause 14. The method according to clause 12 or 13, further comprising indicating at a user interface the remaining useful life for the semiconductor chip.
Clause 15. The method according to any of clauses 12 - 14, wherein estimating the current state of the semiconductor chip comprises estimating accumulated life usage of the semiconductor chip and optionally comprises the method according to clause 4.
Clause 16. The method according to any of clauses 12 - 15, wherein estimating the current state of the semiconductor chip is at least partially based on data from manual inspection of the power converter.
Clause 17. The method according to any of clauses 12 - 16, wherein the early-life degradation model and/or the end-of-life degradation model determine degradation and an indication of uncertainty of the potential degradation.
Clause 18. The method according to any of clauses 12 - 17, wherein the end-of-life degradation model has a sampling rate of between 5 minutes and 2 days for each sample, more specifically between 10 minutes and 1 day.
Clause 19. The method according to any of clauses 12 - 19, wherein the end-of-life degradation model and/or the early-life degradation model is updated based on real life data taking into account similar ambient conditions and/or recency of the real life data.
Clause 20. The method according to any of clauses 12 - 19, wherein the power semiconductor device is a power semiconductor device arranged in a power converter of a wind turbine.

This written description uses examples to disclose the teaching, including the preferred embodiments, and also to enable any person skilled in the art to practice the teaching, including making and using any devices or systems and performing any incorporated methods. The patentable scope is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims. Aspects from the various embodiments described, as well as other known equivalents for each such aspects, can be mixed and matched by one of ordinary skill in the art to construct additional embodiments and techniques in accordance with principles of this application. If reference signs related to drawings are placed in parentheses in a claim, they are solely for attempting to increase the intelligibility of the claim, and shall not be construed as limiting the scope of the claim.

## Claims

1. A method for estimating an operational state of a semiconductor chip of a power semiconductor device, the method comprising:
receiving operational data related to the semiconductor chip over consecutive time intervals;
determining a parameter indicative of an operational state of the semiconductor chip including an indication of uncertainty of the operational state based on the received operational data; and
generating an alert if an alert criterion is fulfilled, wherein the alert criterion is based on the parameter indicative of the operational state of the semiconductor chip and the indication of uncertainty.

2. The method according to claim 1, wherein the parameter indicative of the operational state of the semiconductor chip is a peak junction temperature.

3. The method according to claim 2, wherein the alert criterion comprises a predetermined number of times that a higher bound of the peak junction temperature and the indication of uncertainty thereof exceeds a predefined temperature threshold.

4. The method according to any of claims 1 - 3, wherein the parameter indicative of the operational state of the semiconductor chip is a life usage of the chip, and optionally is a life usage rate or an accumulated life usage of the chip.

5. The method according to claim 4, wherein the alert criterion comprises a difference between a high bound of cumulative life usage at the end of a time period and a low bound of cumulative life usage at a beginning of the time period exceeds a predefined life usage threshold.

6. The method according to claim 4 or 5, wherein the parameter indicative of the operational state of the semiconductor chip is based on a life usage or peak temperature of one or more of a transistor, a diode, a heat sink or a capacitor.

7. The method according to any of claims 1 - 6, wherein the power semiconductor device is a power semiconductor device in a power converter of a wind turbine connected to an electrical grid.

8. The method according to claim 7, wherein the operational data related to the semiconductor chip comprises operational date from the wind turbine and/or the power converter, and optionally comprises one or more of the following: maximum active power of a generator during a time interval, mean active power of the generator during the time interval, standard deviation of active power of the generator, coolant temperature of the converter, mean voltage at the wind turbine and mean reactive power delivered to the grid.

9. The method according to any of claims 1 - 8, wherein the indication of the uncertainty of the operational state includes two or more of the following indicators regarding a parameter indicative of the operational state: mean value, standard deviation, variance, a lower and higher bound with a confidence interval, a minimum, a maximum, a median, a quantile and an interquartile range of the parameter.

10. The method according to any of claims 1 - 9, wherein determining the parameter indicative of an operational state of the semiconductor chip including the indication of uncertainty of the operational state based on the received operational data comprises determining the operational state of the semiconductor chip with an ensemble of models estimating the operational state of the semiconductor chip.

11. The method according to any of claims 1 - 9, wherein determining the parameter indicative of an operational state of the semiconductor chip including the indication of uncertainty of the operational state based on the received operational data comprises determining the operational state of the semiconductor chip with Bayesian inference model, and optionally wherein the Bayesian inference model is stochastic artificial neural network trained using Bayesian inference, wherein an activation function and/or weights in the neural network are stochastic with associated probability distribution.

12. A method for predicting remaining useful life of a semiconductor chip accommodated in a power semiconductor device, the method comprising:
estimating a current operational state of the semiconductor chip according to any of claims 1 - 11;
determining a potential degradation of the semiconductor chip over time as a function of operating conditions of the semiconductor chip;
estimating a remaining useful life for the semiconductor chip based on the estimated current state of the semiconductor chip and the potential degradation

13. A computing system comprising a processor configured to perform any of the methods of claims 1 - 12.

14. A computer program comprising instructions which, when the computer program is executed by a computer, cause the computer to carry out any of the methods of claims 1 - 13.

15. A computer-readable data carrier having stored thereon the computer program of claim 14.
